(19) Europäisches Patentamt
European Patent Office
Office européen des brevets

(11) Veröffentlichungsnummer: **0 024 592**
**B1**

(12) # EUROPÄISCHE PATENTSCHRIFT

(45) Veröffentlichungstag der Patentschrift: **01.06.83**

(51) Int. Cl.³: **C 08 G 73/20**, C 08 G 73/18, G 03 F 7/10, G 03 C 1/68

(21) Anmeldenummer: **80104640.0**

(22) Anmeldetag: **06.08.80**

(54) **Polyimidazol- und Polyimidazopyrrolon-Vorstufen sowie deren Herstellung.**

(30) Priorität: **21.08.79 DE 2933819**

(43) Veröffentlichungstag der Anmeldung: **11.03.81 Patentblatt 81/10**

(45) Bekanntmachung des Hinweises auf die Patenterteilung: **01.06.83 Patentblatt 83/22**

(84) Benannte Vertragsstaaten: **AT BE CH DE FR GB IT LI NL SE**

(56) Entgegenhaltungen:
**DE A 2 308 830**
**DE A 2 462 196**
**US A 3 957 512**
**CHEMICAL ABSTRACTS, Band 88, Nr. 16, 17. April 1978, Seite 534, Zusammenfassung Nr. 113280b, Columbus, Ohio, US, H.J. BOOSS et al.: « Evaluation of a crosslinkable photoresist for use in microtechniques »**
**SIEMENS FORSCHUNG UND ENTWICKELUNGS BERICHTE, Band 5, Nr. 2, Februar 1976, Springer Verlag, Berlin, DE, R. RUBNER: « Production of highly heat-resistant film patterns from photoreactive polymeric precursors », Seite 92-97**
**SIEMENS FORSCHUNGS UND ENTWICKELUNGS BERICHTE, Band 5, Nr. 4, April 1976, Springer Verlag, Berlin, DE, R. RUBNER et al.: « Production of highly heat-resistant film patterns from photoreactive polymeric precursors. Part 2, Polyimide film patterns », Seiten 235-239**

(73) Patentinhaber: **SIEMENS AKTIENGESELLSCHAFT**
**Berlin und München Wittelsbacherplatz 2**
**D-8000 München 2 (DE)**

(72) Erfinder: **Ahne, Hellmut, Dr.**
**Heidestrasse 6**
**D-8551 Röttenbach (DE)**
Erfinder: **Rubner, Roland, Dr.**
**Buchenring 15**
**D-8551 Röttenbach (DE)**
Erfinder: **Kühn, Eberhard**
**Bergstrasse 32**
**D-8551 Hemhofen (DE)**

**EP 0 024 592 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

Polyimidazol- und Polyimidazopyrrolon-Vorstufen sowie deren Herstellung

Die Erfindung betrifft oligomere und/oder polymere Vorstufen von Polyimidazolen und Polyimidazopyrrolonen sowie ein Verfahren zur Herstellung dieser Vorstufen.

Vorstufen von Polymeren sind beispielsweise aus der deutschen Petentschrift 2 308 830 bzw. der entsprechenden US-Patentschrift 3 957 512 bekannt. Diese Polymer-Vorstufen sind Polyadditions- oder Polykondensationsprodukte polyfunktioneller carbocyclischer oder heterocyclischer, strahlungsempfindliche Reste tragender Verbindungen mit Diaminen, Diisocyanaten, Bis-säurechloriden oder Dicarbonsäuren. Die strahlungsempfindliche Reste tragenden Verbindungen enthalten zwei für Additions- oder Kondensationsreaktionen geeignete Carboxyl-, Carbonsäurechlorid-, Amino-, Isocyanat- oder Hydroxylgruppen und teilweise in ortho- oder peri-Stellung dazu esterartig an Carboxylgruppen gebundene strahlungsreaktive Gruppen und die mit diesen Verbindungen umzusetzenden Diamine, Diisocyanate, Bis-säurechloride und Dicarbonsäuren weisen mindestens ein cyclisches Strukturelement auf.

Die bekannten Polymer-Vorstufen dienen zur Herstellung von Schutz- und Isolierschichten sowie von Relief-strukturen aus hochwärmebeständigen Polymeren, in die sie durch Belichtung und gegebenenfalls durch nachfolgendes Tempern übergeführt werden. Dabei werden insbesondere Polymere folgender Stoffklassen erhalten : Polyimide, Polyamidimide, Polyesterimide, Poly-1.3-chinazolin-2.6-dione, Polyisoindolochinazolidione, Poly-1.3-oxazin-6-one und Polybenz-1.3-oxazin-2.4-dione.

Aufgabe der Erfindung ist es, neue Polymer-Vorstufen bereitzustellen, die die Palette von Ausgangsstoffen zur Herstellung von Reliefstrukturen sowie von Schutz- und Isolierschichten verbreitern. Insbesondere sollen strahlungsreaktive Polyimidazol- und Polyimidazopyrrolon-Vorstufen geschaffen werden.

Dies wird erfindungsgemäß dadurch erreicht, daß die Vorstufen aus Additionsprodukten von olefinisch ungesättigten Monoepoxiden an aminogruppenhaltige Polykondensationsprodukte von aromatischen und/oder heterocyclischen Tetraaminoverbindungen mit Dicarbonsäurechloriden oder -estern bzw. an aminogruppenhaltige Polyadditionsprodukte aus den Tetraaminoverbindungen und Tetracarbonsäuredianhydriden bestehen.

Strahlungsreaktive Polyimidazol- und Polyimidazopyrrolon-Vorstufen sind bislang noch nicht bekannt. Die erfindungsgemäßen Verbindungen weisen diese Eigenschaft auf ; sie können daher durch Strahlung vernetzt und dabei in hochwärmebeständige Polymere mit ausgezeichneten Eigenschaften übergeführt werden (vgl. dazu die gleichzeitig eingereichte europäische Patentanmeldung « Verfahren zur Herstellung hochwärmebeständiger Reliefstrukturen und deren Verwendung », EP-A1-0 026 299). Neben der Photostrukturierbarkeit zeichnen sich die erfindungsgemäßen Vorstufen auch noch dadurch aus, daß sie in organischen Lösungsmitteln und zum Teil auch in wäßrig-alkalischen Medien löslich sind.

Die erfindungsgemäßen Polyimidazol-Vorstufen weisen im allgemeinen folgende Struktur (1) oder (2) auf, die Polyimidazopyrrolon-Vorstufen Struktur (3) oder (4) :

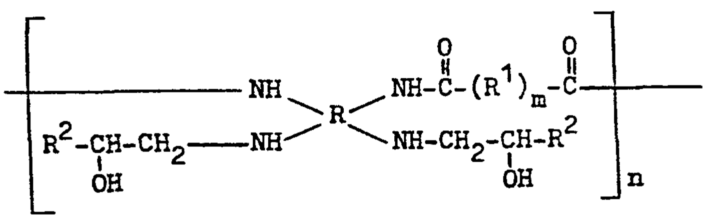

(1)

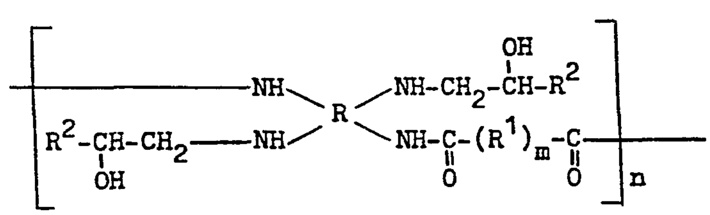

(2)

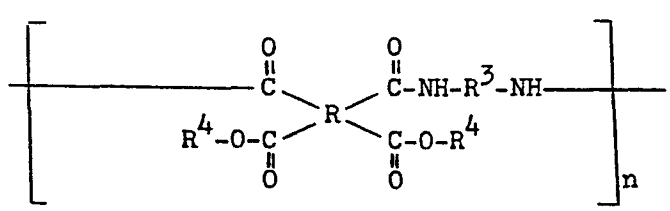

(3)

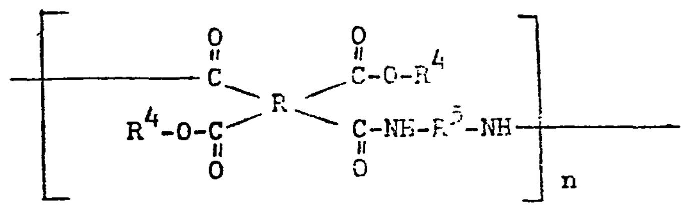

(4)

In den Formeln (1) bis (4) für die Polyimidazol- bzw. Polyimidazopyrrolon-Vorstufen bedeutet n eine ganze Zahl von 2 bis etwa 100 und m = 0 oder 1.

Für R, $R^1$, $R^2$, $R^3$ und $R^4$ gilt folgendes :

R ist ein — gegebenenfalls halogenierter — zumindest partiell aromatischer und/oder heterocyclischer tetravalenter, d. h. tetrafunktioneller Rest, bei dem jeweils zwei Valenzen in Nachbarstellung zueinander angeordnet sind ; weist der Rest R mehrere aromatische und/oder heterocyclische Strukturelemente auf, so befinden sich die Valenzpaare jeweils an endständigen derartigen Strukturelementen ;

$R^1$ ist ein — gegebenenfalls halogenierter — divalenter, d. h. difunktioneller Rest aliphatischer und/oder cycloaliphatischer, gegebenenfalls Heteroatome aufweisender, und/oder aromatischer und/oder heterocyclischer Struktur ;

$R^2$ ist ein olefinisch ungesättigter Rest, insbesondere eine — gegebenenfalls substituierte — meth(acryl) esterhaltige Gruppe ;

$R^3$ ist ein zumindest partiell aromatischer und/oder heterocyclischer divalenter, d. h. difunktioneller Rest, bei dem wenigstens zu einer der beiden Valenzen in Nachbarstellung eine Aminogruppe angeordnet ist ; weist $R^3$ mehrere aromatische und/oder heterocyclische Strukturelemente auf, so befinden sich die freien Valenzen jeweils an endständigen derartigen Strukturelementen ;

$R^4$ ist Wasserstoff oder ein $R^2$-substituierter Hydroxyalkylrest.

Die Reste R, $R^1$, $R^2$, $R^3$ und $R^4$ haben insbesondere folgende Bedeutung :

R = 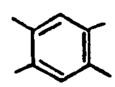 , 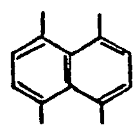 , 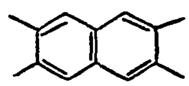 ,

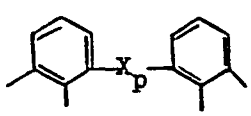 , 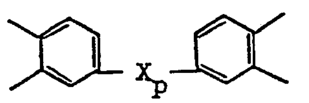 ,

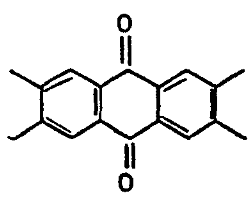 , 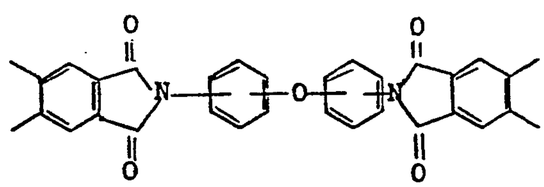 ,

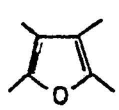 und 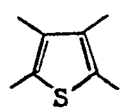 ,

wobei p = 0 oder 1 ist und X für einen der folgenden Reste steht.

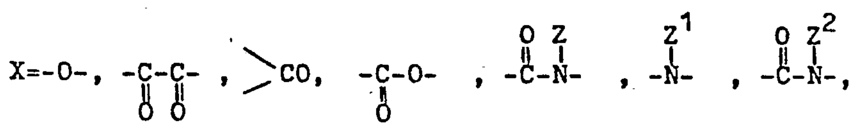

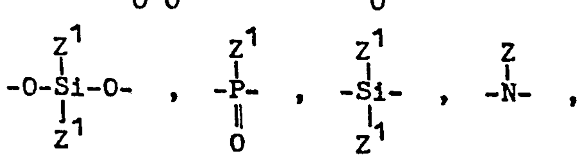

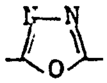 , 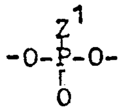 , 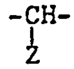 , 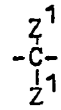 , 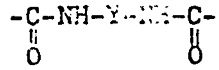 ,

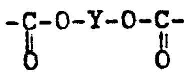 , $-SO-$ , $-SO_2-$ , $-SO_2NH-$ , $-S-$ ,

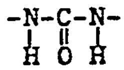 , $-N{=}N-$ , 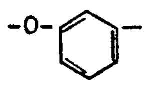 , 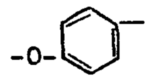 ,

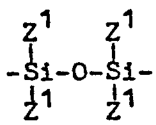 und 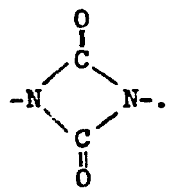

Für die weiteren Reste gilt :

Y = 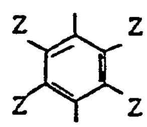 , $-(CH_2)_o-$ mit o = 2 bis 10,

und

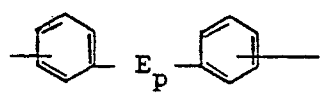 mit p = 0 oder 1,

Z = H oder Alkyl mit 1 bis 6 Kohlenstoffatomen,
$Z^1$ = Alkyl mit 1 bis 10 Kohlenstoffatomen oder Aryl
$Z^2$ = Aryl oder Heteroaryl, und

E = 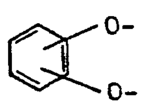 , 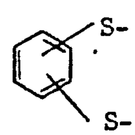 , 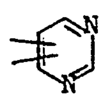 , 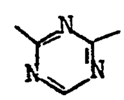 ,

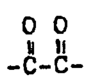 , 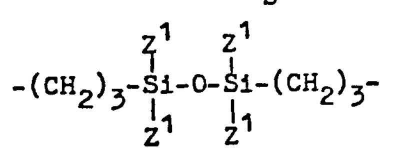 , 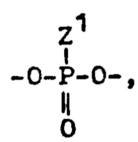 , 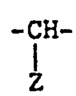 ,

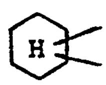 , $-(CH_2)_q-$ , $-(CF_2)_r-$ , $-SO-$ , 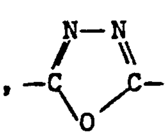 ,

$-SO_2NH-$ , 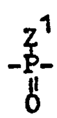 , 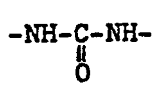 , 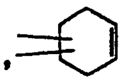 , $-N{=}N-$ , $-S-$ ,

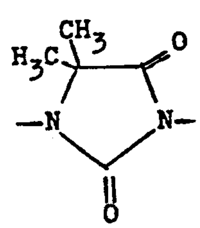 , $-O-$ , 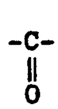 , 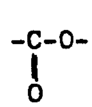 , 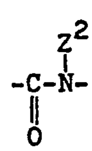 , 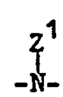 , 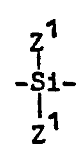 ,

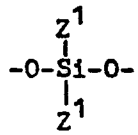 , 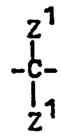 , $-SO_2-$ und 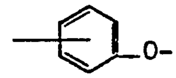 ,

wobei q = 2 bis 14 und r = 2 bis 18, und $Z^1$ und $Z^2$ wie vorstehend definiert sind.

$R^1$ = 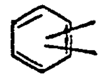 , 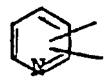 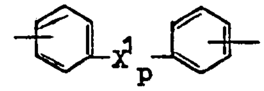 ,

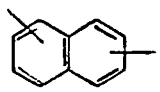 , 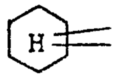 , $-(CH_2)_q-$ , $-(CF_2)_r-$ ,

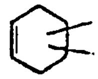 , 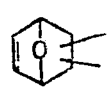 , 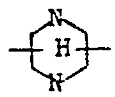 und

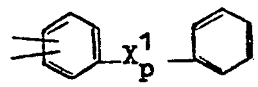 ,

wobei p = 0 oder 1, q = 2 bis 14 und r = 2 bis 18.

$X^1$ = -O- , 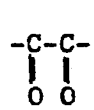 , 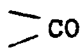 , 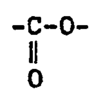 , 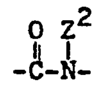 , 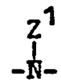 , 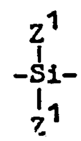 ,

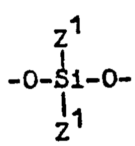 , 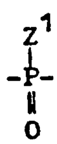 , 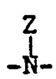 , 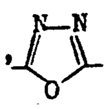 , 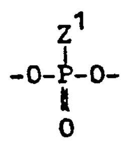 , 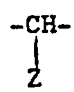 , 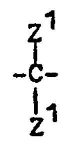 ,

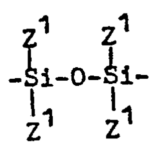 , 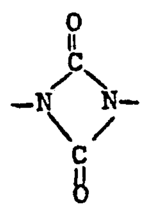 , -SO- , $-SO_2-$ , $-SO_2NH-$ , -S- ,

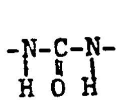 , -N=N- , 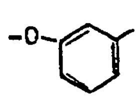 , 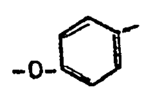 und

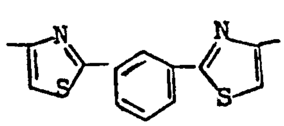 ,

wobei Z, $Z^1$ und $Z^2$ wie vorstehend definiert sind.

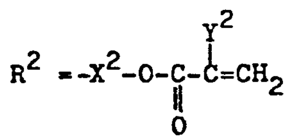,
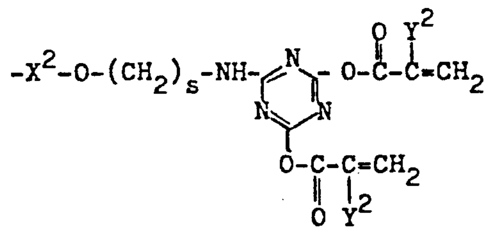

und $-X^2-O-CH_2-CH=CH_2$;
dabei ist s = 2 bis 16;
für die weiteren Reste gilt:
$X^2 = -CH_2-$ und $-CH_2-O-[(CH_2)_r-O]_t-(CH_2)_s-$, und
$Y_2 = -H, -CH_3, -Cl, -Br, -C{\equiv}N$,
wobei r = 2 bis 18, s = 2 bis 16 und t = 0 bis 10.

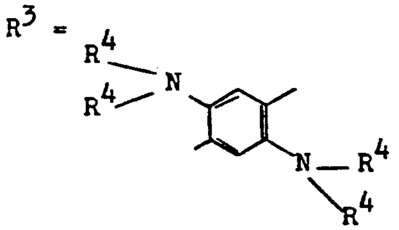,
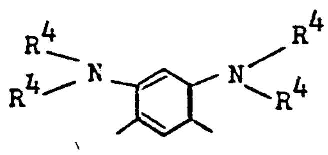,

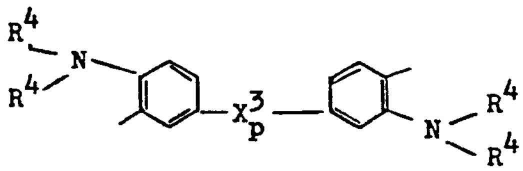 und

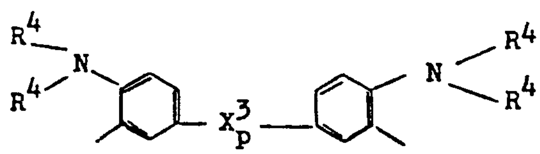;

dabei ist p = 0 oder 1 und $X^3$ hat die vorstehend für $X^1$ angegebene Bedeutung.

$R^4$ = H und 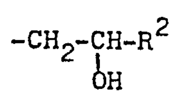

mit der vorstehend angegebenen Bedeutung für $R^2$.

Die erfindungsgemäßen Polymer-Vorstufen sind Additionsprodukte von olefinisch ungesättigten Monoepoxiden an aminogruppenhaltige Prepolymere. Diese Prepolymere sind:

— Polykondensationsprodukte von aromatischen und/oder heterocyclischen Tetraaminoverbindungen mit Dicarbonsäurechloriden oder -estern (Polyimidazol-Prepolymere);

— Polyadditionsprodukte aus aromatischen und/oder heterocyclischen Tetraaminoverbindungen und Tetracarbonsäuredianhydriden (Polyimidazopyrrolon-Prepolymere).

Die bevorzugt eingesetzte Tetraaminoverbindung ist Diaminobenzidin, das bevorzugte Dicarbonsäurederivat ist Isophthalsäuredimethylester und das bevorzugte Tetracarbonsäuredianhydrid Pyromellithsäuredianhydrid.

An die genannten aminogruppenhaltigen Prepolymeren, die Polyimidazopyrrolone enthalten im übrigen auch Carboxylgruppen, werden olefinisch ungesättigte Monoepoxide addiert. Diese Epoxide weisen folgende Struktur (5) auf, wobei der ungesättigte Rest $R^2$ die vorstehend angegebene Bedeutung besitzt:

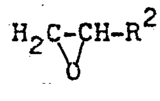

(5)

Bevorzugt werden die ungesättigten Epoxide Glycidylacrylat und -methacrylat.

Anhand der nachfolgenden Formeln (6) und (7) wird die Struktur der erfindungsgemäßen Vorstufen beispielhaft verdeutlicht :

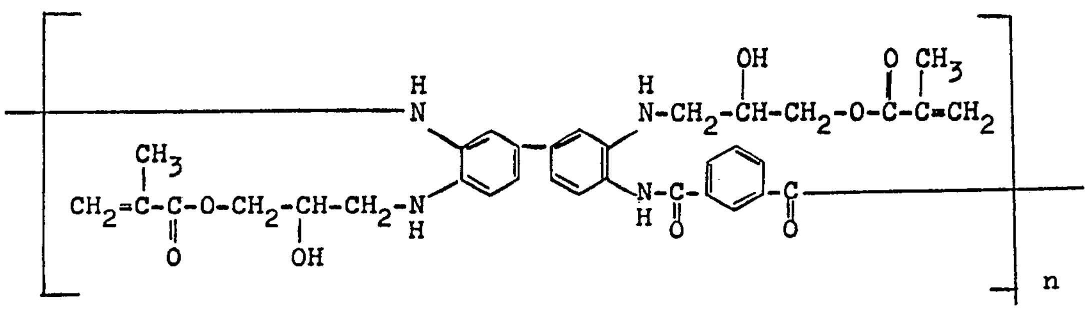

(6)

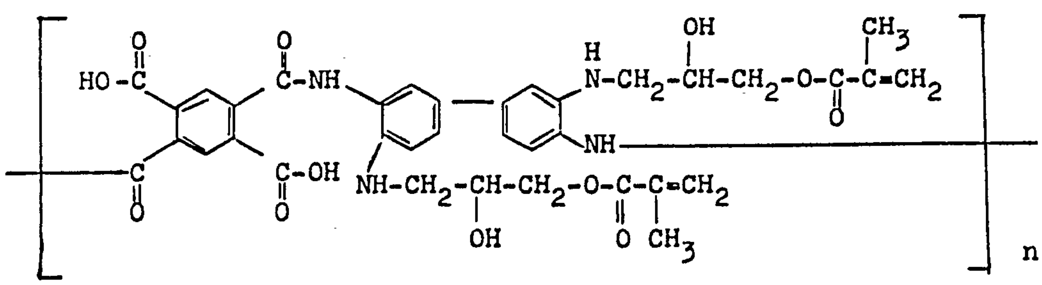

(7)

In Formel (6) ist dabei eine strahlungsreaktive Polyimidazol-Vorstufe dargestellt und zwar das Additionsprodukt von Glycidylmethacrylat an das Polykondensationsprodukt von Diaminobenzidin und Isophthalsäuredimethylester. Formel (7) zeigt das Additionsprodukt von Glycidylmethacrylat an das Polyadditionsprodukt von Diaminobenzidin und Pyromellithsäuredianhydrid, d. h. eine Polyimidazopyrrolon-Vorstufe.

Die erfindungsgemäßen Vorstufen weisen als Grundbausteine bevorzugt aromatische Aminoverbindungen auf und ergeben somit bei der thermischen Behandlung Polymere mit der Struktureinheit (8) bzw. (9) :

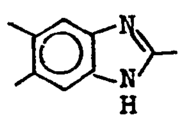

(8)

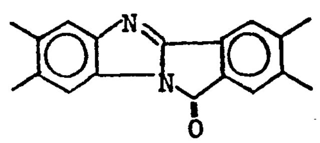

(9)

Polyimidazol

Polyimidazopyrrolon

Die erfindungsgemäßen Polyimidazol- und Polyimidazopyrrolon-Vorstufen werden vorteilhaft in der Weise hergestellt, daß eine aromatische und/oder heterocyclische Tetraaminoverbindung mit einem Dicarbonsäurechlorid oder -ester bzw. mit einem Tetracarbonsäuredianhydrid zu einem aminogruppenhaltigen Reaktionsprodukt umgesetzt wird und daß das Reaktionsprodukt bei Raumtemperatur oder bei Temperaturen bis ca. 100 °C in einem organischen Lösungsmittel mit einem olefinisch ungesättigten Monoepoxid zur Reaktion gebracht wird.

Dieses Verfahren weist den Vorteil auf, daß es präparativ einfach durchzuführen ist, wobei im allgemeinen Reaktionstemperaturen von ca. 50 bis 60 °C ausreichend sind, d. h. Temperaturen, bei denen noch keine Umwandlung der Vorstufen in unlösliche Cyclisierungsprodukte erfolgt. Die Endprodukte fallen im reinen Zustand an, wobei weiter überraschend ist, daß bei der Umsetzung keine vorzeitige thermische Vernetzung der Vorstufen erfolgt.

Bei der Umsetzung von Polyadditionsprodukten aus Tetraaminoverbindungen und Tetracarbonsäuredianhydriden mit Monoepoxiden entstehen bei der Verwendung überschüssiger Mengen an Epoxid Polyimidazopyrrolon-Vorstufen, die in wäßriger alkalischer Lösung unlöslich sind. Hierbei reagieren nämlich auch die freien Carboxylgruppen des Prepolymeren mit dem Epoxid. Vorteilhaft wird jedoch eine geringere Menge an Epoxid verwendet, d. h. ein Überschuß an dem Polyadditionsprodukt. In diesem Fall ist nämlich die Vorstufe — aufgrund der vorhandenen Carboxylgruppen — in wäßrig-alkalischen Lösungen löslich.

Außer zur Verwendung als Photoresist und zur Herstellung von Schutz- und Isolierschichten, wobei

eine Strukturierung erfolgt, können die erfindungsgemäßen Vorstufen auch allgemein — in nicht strukturierter Form — zur Herstellung von Schutz- und Isolierüberzügen dienen. Besonders vorteilhaft können diese Vorstufen dabei zur Herstellung von Kunststoffüberzügen für die Lichtleitfasern von Lichtwellenleitern verwendet werden.

Anhand von Ausführungsbeispielen soll die Erfindung noch näher erläutert werden.

Beispiel 1

Herstellung einer strahlungsreaktiven Polybenzimidazol-Vorstufe

10,7 Gewichtsteile 3.3'-Diaminobenzidin werden in 95 Volumenteilen N-Methylpyrrolidon gelöst und zusammen mit 9,7 Gewichtsteilen Isophthalsäuredimethylester 8 Stunden lang auf eine Temperatur von 150 bis 175 °C und anschließend 2 Tage auf ca. 185 °C erhitzt. Zu dieser Lösung werden 20 Volumenteile Glycidylmethacrylat gegeben. Nach einer Reaktionsdauer von 48 Stunden bei Raumtemperatur und 4 Stunden bei etwa 50 bis 60 °C wird die Vorstufe mit 800 Volumenteilen Isopropanol ausgefällt, mit Äthanol gewaschen und im Vakuum getrocknet. Das erhaltene gelbbraune Produkt zeigt im IR-Spektrum (Film) die für die Methacrylatgruppierung typischen Banden bei 950 und 1 290 $cm^{-1}$.

Beispiel 2

Herstellung einer in wäßrig-alkalischer Lösung löslichen Polyimidazopyrrolon-Vorstufe

In einem mit Stickstoff gespülten Reaktionskolben wird eine Lösung von 21,4 Gewichtsteilen (0,1 Mol) Diaminobenzidin in 190 Volumenteilen Dimethylacetamid vorgelegt. Zu dieser Lösung werden zunächst unter kräftigem Rühren rasch 190 Volumenteile einer Lösung von 21,8 Gewichtsteilen Pyromellithsäuredianhydrid (0,1 Mol) in 195 Volumenteilen Dimethylacetamid gegeben. Die erhaltene Prepolymer-Lösung wird ca. 30 Minuten langsam gerührt, wobei sie sich auf Raumtemperatur abkühlt. Danach wird die restliche Pyromellithsäuredianhydridlösung zugetropft. Nach beendeter Zugabe dieser Lösung wird die strohgelbe Prepolymer-Lösung leicht viskos. Wichtig ist dabei, daß reine Ausgangsmaterialien und Lösungsmittel verwendet werden.

Zu 44 Volumenteilen der in der vorstehend beschriebenen Weise erhaltenen Prepolymer-Lösung werden bei Raumtemperatur unter Rühren 15 Gewichtsteile Glycidylmethacrylat (0,1 Mol) getropft. Nach etwa 30 Minuten wird die Reaktionslösung für 12 Stunden auf etwa 50 bis 60 °C erwärmt, danach auf Raumtemperatur abgekühlt und für 48 Stunden stehengelassen. Anschließend wird die Lösung unter kräftigem Rühren zu 1 000 Volumenteilen Isopropanol getropft. Hierbei scheidet sich eine gelbbraune Substanz ab, die im Vakuum getrocknet wird. Die auf diese Weise erhaltene Polyimidazopyrrolon-Vorstufe ist in wäßrig-alkalischen Lösungsmitteln und in polaren organischen Lösungsmitteln, wie Dimethylacetamid, Dimethylformamid und N-Methylpyrrolidon, löslich.

Das IR-Spektrum, gemessen an einem Film, zeigt typische Banden bei 950 und 1 290 $cm^{-1}$ (Methacrylatbanden), bei 1 720 $cm^{-1}$ (Esterbande) und bei 1 670 $cm^{-1}$ (Absorptionsbande sekundärer Amide). Das Vorhandensein von Carboxylgruppen ergibt sich insbesondere aus der Löslichkeit in wäßrig-alkalischen Lösungsmitteln.

Beispiel 3

Herstellung einer in wäßrig-alkalischer Lösung unlöslichen Polyimidazopyrrolon-Vorstufe

Zu 45 Volumenteilen der Prepolymer-Lösung nach Beispiel 2 werden bei Raumtemperatur unter kräftigem Rühren 50 Gewichtsteile Glycidylmethacrylat (0,35 Mol) getropft. Nach 2stündiger Reaktionsdauer wird für 3 Stunden auf eine Temperatur von etwa 90 bis 100 °C erwärmt. Danach wird filtriert und das Harz aus 500 Volumenteilen Äthanol gefällt. Nach dem Trocknen in Vakuum wird ein braunes Pulver erhalten, das sich in wäßrig-alkalischer Lösung nicht mehr löst. Dies bedeutet, daß praktisch keine freien Carboxylgruppen mehr vorliegen, sondern diese vielmehr — infolge der Verwendung eines großen Überschusses an Glycidylmethacrylat — verestert sind.

Im Vergleich zum IR-Spektrum einer Polyimidazopyrrolon-Vorstufe nach Beispiel 2 zeigt das vorliegende Produkt einen starken Rückgang der Absorption im Bereich zwischen 3 000 und 3 300 $cm^{-1}$ (fehlende Carboxylgruppen). Eine deutliche Bande findet sich bei 3 400 $cm^{-1}$, die der OH-Gruppe zugeschrieben werden kann. Für die Struktur des Reaktionsproduktes sprechen ferner die Absorptionsbanden bei 950 und 1 290 $cm^{-1}$, die der Methacrylatgruppierung zuzuordnen sind, sowie die Esterbande bei 1 720 $cm^{-1}$. Die genannten Banden sind im IR-Spektrum des entsprechenden Prepolymeren nicht vorhanden.

**Ansprüche**

1. Oligomere und/oder polymere Vorstufen von Polyimidazolen und Polyimidazopyrrolonen, dadurch gekennzeichnet, daß sie aus Additionsprodukten von olefinisch ungesättigten Monoepoxiden an aminogruppenhaltige Polykondensationsprodukte von aromatischen und/oder heterocyclischen Tetraaminoverbindungen mit Dicarbonsäurechloriden oder -estern bzw. an aminogruppenhaltige Polyadditionsprodukte aus den Tetraaminoverbindungen und Tetracarbonsäuredianhydriden bestehen.

2. Polyimidazol- und Polyimidazopyrrolon-Vorstufen nach Anspruch 1, dadurch gekennzeichnet, daß das ungesättigte Monoepoxid Glycidylacrylat oder -methacrylat ist.

3. Polyimidazol-Vorstufen nach Anspruch 1 oder 2, gekennzeichnet durch ein Polykondensationsprodukt aus Diaminobenzidin und Isophthalsäuredimethylester.

4. Polyimidazopyrrolon-Vorstufen nach Anspruch 1 oder 2, gekennzeichnet durch ein Polyadditionsprodukt aus Diaminobenzidin und Pyromellithsäuredianhydrid.

5. Verfahren zur Herstellung von Polyimidazol- und Polyimidazopyrrolon-Vorstufen nach einem der Ansprüche 1 bis 4, dadurch gekennzeichnet, daß eine aromatische und/oder heterocyclische Tetraaminoverbindung mit einem Dicarbonsäurechlorid oder -ester bzw. mit einem Tetracarbonsäuredianhydrid zu einem aminogruppenhaltigen Reaktionsprodukt umgesetzt wird und daß das Reaktionsprodukt bei Raumtemperatur oder bei Temperaturen bis ca. 100 °C in einem organischen Lösungsmittel mit einem olefinisch ungesättigten Monoepoxid zur Reaktion gebracht wird.

6. Verfahren nach Anspruch 5, dadurch gekennzeichnet, daß das Reaktionsprodukt aus Tetraaminoverbindung und Tetracarbonsäuredianhydrid bei der Umsetzung mit dem Monoepoxid im Überschuß eingesetzt wird.

7. Verwendung der Polyimidazol- und Polyimidazopyrrolon-Vorstufen nach einem der Ansprüche 1 bis 4 zur Herstellung von Kunststoffüberzügen für die Lichtleitfasern von Lichtwellenleitern.

**Claims**

1. Oligomeric and/or polymeric precursors of polyimidazoles and polyimidazopyrrolones, characterised in that they consist of addition products of olefinically-unsaturated mono-epoxides with amino-group-containing polycondensation products of aromatic and/or heterocyclic tetra-amino-compounds with dicarboxylic acid chlorides or esters, or with amino-group-containing polyaddition products of the tetra-amino-compounds and tetracarboxylic acid dianhydrides.

2. Polyimidazole and polyimidazopyrrolone precursors as claimed in Claim 1, characterised in that the unsaturated mono-epoxide is glycidyl acrylate of methacrylate.

3. Polyimidazole precursors as claimed in Claim 1 or Claim 2, characterised by a polycondensation product of diaminobenzidine and isophthalic acid dimethylester.

4. Polyimidazopyrrolone precursors as claimed in Claim 1 of Claim 2, characterised by a polyaddition product of diaminobenzidine and pyromellitic acid dianhydride.

5. A process for the production of polyimidazole and polyimidazopyrrolone precursors as claimed in one of Claims 1 to 4, characterised in that an aromatic and/or heterocyclic tetra-amino-compound is reacted with a dicarboxylic acid chloride or dicarboxylic acid ester, or with a tetracarboxylic acid dianhydride to form a reaction product containing amino groups ; and that the reaction product is reacted in an organic solvent with an olefinically-unsaturated mono-epoxide at room temperature or at temperatures of up to about 100 °C.

6. A process as claimed in Claim 5, characterised in that the reaction product of a tetra-amino-compound and a tetracarboxylic acid dianhydride is used in excess during the reaction with the mono-epoxide.

7. The use of the polyimidazole precursors and polyimidazopyrrolone precursors as claimed in one of Claims 1 to 4 for the production of plastics coatings for the light-conducting fibres of light waveguides.

**Revendications**

1. Précurseurs oligomères et/ou polymères de polyimidazoles et de polyimidazopyrrolones, caractérisés en ce qu'ils sont constitués de produits d'addition de monoépoxydes oléfiniquement insaturés sur des produits de polycondensation, contenant des groupes amino de composés tétraamino aromatiques et/ou hétérocycliques, avec des chlorures d'acides dicarboxyliques ou avec des esters d'acides dicarboxyliques ou sur des produits de polyaddition, contenant des groupes amino, de ces composés tétraamino et de dianhydrides d'acides tétracarboxyliques.

2. Précurseurs de polyimidazoles et de polyimidazopyrrolones suivant la revendication 1, caractérisés en ce que le monoépoxyde insaturé est l'acrylate de glycidyle ou le méthacrylate de glycidyle.

3. Précurseurs de polyimidazoles suivant la revendication 1 ou 2, caractérisés par un produit de polycondensation de la diaminobenzidine et de l'ester diméthylique de l'acide isophtalique.

4. Précurseurs de polyimidazopyrrolones suivant la revendication 1 ou 2, caractérisés par un produit de polyaddition de la diaminobenzidine et du dianhydride de l'acide pyromellitique.

5. Procédé de préparation de précurseurs de polyimidazoles et de polyimidazopyrrolones suivant l'une des revendications 1 à 4, caractérisé en ce qu'il consiste à transformer un composé tétraamino

aromatique et/ou hétérocyclique en un produit de réaction contenant des groupes amino, par un chlorure d'acide dicarboxylique, ou par un ester d'acide dicarboxylique, ou par un dianhydride d'acide tétracarboxylique, et à mettre à réagir le produit de réaction sur un monoépoxyde oléfiniquement insaturé dans un solvant organique à la température ambiante ou à des températures allant jusqu'à 100 °C environ.

6. Procédé suivant la revendication 5, caractérisé en ce que le produit de réaction du composé tétramino et du dianhydride d'acide tétracarboxylique est engagé en excès lors de la réaction sur le monoépoxyde.

7. Utilisation des précurseurs de polyimidazoles et de polyimidazopyrrolones suivant l'une des revendications 1 à 4, pour la préparation de revêtements en matière plastique destinés à des fibres optiques de guides d'ondes lumineuses.